(19) **Europäisches Patentamt / European Patent Office / Office européen des brevets**

(11) **EP 4 377 706 B1**

(12) **EUROPÄISCHE PATENTSCHRIFT**

(45) Veröffentlichungstag und Bekanntmachung des Hinweises auf die Patenterteilung:
**10.12.2025   Patentblatt 2025/50**

(21) Anmeldenummer: **23703775.9**

(22) Anmeldetag: **06.02.2023**

(51) Internationale Patentklassifikation (IPC):
**G01R 31/28** (2006.01)  **H01L 23/544** (2006.01)
**G05B 13/02** (2006.01)  **G05B 19/418** (2006.01)

(52) Gemeinsame Patentklassifikation (CPC):
**G05B 19/41875; G05B 13/0265;** G05B 2219/37224; G06N 20/00

(86) Internationale Anmeldenummer:
**PCT/EP2023/052855**

(87) Internationale Veröffentlichungsnummer:
**WO 2023/161001 (31.08.2023 Gazette 2023/35)**

(54) **UNSICHERHEITSABSCHÄTZUNG EINER POSITIONSREKONSTRUKTION VON HALBLEITERBAUTEILEN AUF EINEM WAFER**

UNCERTAINTY ESTIMATION FOR A POSITION RECONSTRUCTION OF SEMICONDUCTOR COMPONENTS ON A WAFER

ESTIMATION DE L'INCERTITUDE POUR UNE RECONSTRUCTION DE LA POSITION DE COMPOSANTS SEMI-CONDUCTEURS SUR UNE TRANCHE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **25.02.2022   DE 102022201967**

(43) Veröffentlichungstag der Anmeldung:
**05.06.2024   Patentblatt 2024/23**

(73) Patentinhaber: **Robert Bosch GmbH**
**70442 Stuttgart (DE)**

(72) Erfinder:
- **SCHMIDT, Eric Sebastian**
  **71296 Heimsheim (DE)**
- **LINDT, Stefan Patrick**
  **70839 Gerlingen (DE)**

(56) Entgegenhaltungen:
**US-A- 5 256 578     US-B2- 7 868 474**

**Beschreibung**

Die Erfindung betrifft ein Verfahren zum Abschätzen einer Unsicherheit einer Zuordnungsvorschrift für eine Rekonstruktion von Positionen von Halbleiterbauteilen auf einem Wafer, auf welchem diese aufgetragen wurden, nach dem die Halbleiterbauteile aus dem Wafer herausgeschnitten wurden, sowie eine Vorrichtung, welche eingerichtet ist, das Verfahren auszuführen.

Stand der Technik

Beim Packaging-Prozess von Halbleiterbauteilen (im speziellen von PowerMOS) geht die Rückverfolgbarkeit der Halbleiterbauteilen zu deren ursprünglichen Wafer und deren ursprünglichen Position auf dem Wafer verloren. Konkret bedeutet dies, dass die Position jedes Halbleiterbauteiles auf einem Wafer nicht mehr verfügbar ist, sobald der Wafer zerschnitten bzw. gewürfelt (engl. ‚diced' = ein Verfahren, bei dem Halbleiterbauteil vom Wafer getrennt werden) und verpackt wurde. Anbieter von Packaging-Prozessen sind in der Lage zumindest ein grobes Matching zwischen losen Halbleiterbauteilen in der Endprüfung (engl. ‚Final Test' = Prüfprozess der Halbleiterbauteile nach der Verpackung) und Halbleiterbauteilen auf dem Wafer in Wafer-Level-Tests (Prüfprozess vor dem Verpacken) anzubieten. Jedoch führt dies immer noch zu mehreren tausend nicht zuordenbaren Halbleiterbauteile zu mehreren Wafern. Da es sich hierbei im Wesentlichen um ein kombinatorisches Problem handelt, ist die Komplexität der Lösung dieser Aufgabe faktoriell, da es n-Fakultät viele verschiedene Möglichkeiten gibt, die Halbleiterbauteile so anzuordnen, dass sie der richtigen Reihenfolge entsprechen, wobei n die Anzahl der Halbleiterbauteile ist.

Für ASIC- Halbleiterbauteile gibt es eine Lösung für dieses kombinatorische Problem. Hierfür wird während des Wafer-Level-Tests ein eindeutiger Identifikator im Speicher der ASIC- Halbleiterbauteile gespeichert, der eine Zuordnung der Endprüfung zu dem Wafer-Level Test nach dem Verpacken ermöglicht. Bei Halbleiterbauteilen wie PowerMOS ist dies jedoch aufgrund eines fehlenden Speichers nicht möglich.

Aus der nicht-vorveröffentlichen DE 10 2021 209 343 ist ein Verfahren bekannt, um eine Zuordnungsvorschrift zwischen Halbleiterbauteilen abhängig von Ergebnissen des Wafer-Level-Tests und verpackten Halbleiterbauteilen abhängig von Ergebnissen der Endprüfung (engl. Final Test) zu ermitteln.

Aus der US 7 868 474 B2 sind ein Verfahren und Strukturen zum Indizieren von Chips bekannt.

Aus der US 5 256 578 A ist eine integrale Aufzeichnung von Halbleiterwafern bekannt.

Vorteile der Erfindung

Die Erfindung mit den Merkmalen des unabhängigen Anspruchs 1 hat den Vorteil, dass diese es ermöglicht, eine probabilistische Aussage hinsichtlich einer Verlässlichkeit dieser Zuordnungsvorschrift auszugeben und es kommt dabei ohne hinzugefügte Metadaten, wie eindeutige Identifikatoren o.ä., aus.

Die Erfindung hat ferner den Vorteil, dass anhand dieser ermittelten Verlässlichkeit eine bessere Prozesskontrolle der Produktion (z.B. Ursachenanalyse von Fehlerteilen) ermöglicht wird.

Weitere Aspekte der Erfindung sind Gegenstand der nebengeordneten Ansprüche. Vorteilhafte Weiterbildungen sind Gegenstand der abhängigen Ansprüche.

Offenbarung der Erfindung

In einem ersten Aspekt betrifft die Erfindung ein insbesondere computerimplementiertes Verfahren zum Abschätzen einer Unsicherheit einer Zuordnungsvorschrift, die erste Größen aus einer ersten Menge von ersten Größen zweiten Größen aus einer zweiten Menge von zweiten Größen zuordnet. Die Zuordnungsvorschrift kann auf eine eindeutige Weise die ersten Größen den zweiten Größen zuordnen, d.h. dass jeder ersten Größe höchstens eine zweite Größe durch die Zuordnungsvorschrift zugeordnet wird und vorzugsweise auch andersherum. Unter einer Menge kann eine Form einer Zusammenfassung der einzelnen Größen verstanden werden. Vorzugsweise sind die erste und zweite Menge unterschiedliche Mengen, die keine gemeinsame Größe aufweisen. Vorzugsweise ist den Größen der ersten und zweiten Menge jeweils ein Index zugeordnet. Alle Indizes der ersten und zweiten Menge könnten als Indexmengen aufgefasst werden. Also als eine Menge, deren Elemente die Größen der ersten oder zweiten Menge durchindizieren. Die Zuordnungsvorschrift weist dann der ersten Indexmenge jeweils ein Index aus der zweiten Indexmenge zu. Die Zuordnungsvorschrift beschreibt demnach welche erste Größe zu welcher zweiten Größe gehört und vorzugsweise auch andersherum. Die Zuordnungsvorschrift kann als eine Liste oder Tabelle oder ähnlichem vorliegen.

Das Verfahren beginnt mit einem Bereitstellen eines maschinellen Lernsystems, welches unter Verwendung der Zuordnungsvorschrift angelernt wurde, um die ersten Größen gemäß der Zuordnungsvorschrift den zweiten Größen zuzuordnen. Das maschinelle Lernsystem kann ein oder eine Mehrzahl von Entscheidungsbäumen (englisch: decision tree), ein neuronales Netz, eine Support Vector Machine, oder ähnliches sein. Es sei angemerkt, dass vorzugsweise die Zuordnungsvorschrift und das maschinelle Lernsystem alternierend miteinander erstellt und angelernt werden. Besonders bevorzugt wird hier auf das Verfahren der DE 10 2021 209 343 zurückgegriffen.

Daraufhin folgt ein Ermitteln von Ungenauigkeiten des maschinellen Lernsystems, wobei die Ungenauigkeiten mittels einer Differenz zwischen den vorhergesagten zweiten Größen durch das maschinelle Lernsystem abhängig von den ersten Größen und den den ersten Größen zugeordneten zweiten Größen gemäß der Zuordnungsvorschrift ermittelt werden. Die Differenz ist vorzugsweise ein Residuum zwischen der Vorhersage des maschinellen Lernsystems und der zugeordneten zweiten Größe. Daraufhin folgt ein Ermitteln einer Kovarianzmatrix abhängig von den ermittelten Ungenauigkeiten. Daraufhin folgt ein Ermitteln einer Likelihood-Matrix, wobei hierfür die ermittelten Ungenauigkeiten zu einem Vektor gruppiert werden, wobei der Vektor transponiert mit der invertierten Kovarianzmatrix multipliziert und das Ergebnis hiervon mit dem Vektor multipliziert wird. Daraufhin folgt ein Normalisieren der Likelihood-Matrix, indem die Werte/Einträge der Likelihood-Matrix durch die entsprechenden Spaltensummen dividiert werden. In einem optionalen Schritt kann ein Ausgeben der normalisierten Likelihood-Matrix erfolgen. Die Einträge der Likelihood-Matrix geben vorzugsweise eine Wahrscheinlichkeit an, wie sicher bzw. zuverlässig die dem Eintrag [i,j] zugeordnete j-te erste Größe und die diesem Eintrag zugeordnete i-te zweite Größe durch das maschinelle Lernsystem, insbesondere durch die Zuordnungsvorschrift, zugeordnet wären.

Das Verfahren ermöglicht es, die in dem maschinellen Lernsystem innewohnende (aleatorische) Unsicherheit im Wesentlichen probabilistisch zu quantifizieren, da selbst ein perfektes Modell Schwierigkeiten haben kann, zwischen sehr ähnlichen Bauteilen/Chips zu unterscheiden. Damit ist es nun möglich über die aleatorische Unsicherheit des maschinellen Lernsystems eine Unsicherheits- bzw. Verlässlichkeits-abschätzung der Zuordnungsvorschrift zu ermitteln.

Die ersten und/oder zweiten Größen können Skalare oder Vektoren wie z.B. eine Zeitreihe sein, insbesondere von einem Sensor erfasst oder indirekt ermittelte Sensordaten sein. Vorzugsweise sind die ersten und zweiten Größen jeweils ein oder eine Mehrzahl von Messergebnissen von einer Messung oder von einer Mehrzahl von unterschiedlichen Messungen, die jeweils an einem Gegenstand einer Mehrzahl von Gegenständen ausgeführt wurden. D.h. jede Größe ist einem der Gegenstände zugeordnet. Die Zuordnungsvorschrift kann angeben, welche ersten und zweiten Größen Messergebnisse des gleichen Gegenstandes sind. Besonders bevorzugt wurde die zumindest eine Messung der Gegenstände für die ersten Größen zu einem ersten Zeitpunkt und die Messung für die zweiten Größen zu einem zweiten Zeitpunkt ausgeführt, wobei der zweite Zeitpunkt nach dem ersten Zeitpunkt liegt. Der zweite Zeitpunkt kann dann gegeben sein, nachdem die Gegenstände einer Modifikation oder Veränderung unterworfen wurden.

Es wird vorgeschlagen, dass beim Ermitteln der Likelihood-Matrix, zusätzlich das Ergebnis der Vektor-Matrix-Vektor Multiplikation mit einem vorgegeben Wert skaliert wird und wobei eine Exponentialfunktion auf dieses skalierte Ergebnis angewendet wird. Vorzugsweise ist der vorgegebene Wert kleiner 1, besonders bevorzugt beträgt der Wert 0.5.

Dies hat den Vorteil, dass nun eine probabilistische Betrachtung der Unsicherheiten möglich ist. Mathematisch kann dies wie folgt ausgedrückt werden:

$$L_{ij} = \exp\left(-\frac{1}{2}\Big(y_j - f(x_i)\Big)^T \Sigma^{-1} \Big(y_j - f(x_i)\Big)\right)$$

wobei $f(x_i)$ die Vorhersage des maschinellen Lernsystem abhängig von der ersten Größe x ist und y die zweite Größe beschreibt und $\Sigma$ die Kovarianzmatrix ist.

Weiterhin wird vorgeschlagen, dass das maschinelle Lernsystem ein Regressionsmodell ist, welches abhängig von den ersten Größen und Parameter des Regressionsmodells die zweiten Größen ermittelt, wobei beim Anlernen die Parameter des Regressionsmodells angepasst werden. Vorzugsweise ist das Regressionsmodell ein lineares Regressionsmodell.

Die Regression dient dazu Beziehungen zwischen einer abhängigen (oft auch erklärte Variable) und einer oder mehreren unabhängigen Variablen (oft auch erklärende Variablen) zu modellieren. Die Regression ist in der Lage eine komplexere Funktion zu parametrisieren, sodass diese Daten nach einem bestimmten mathematischen Kriterium am besten wiedergibt. Beispielsweise berechnet die gewöhnliche Methode der kleinsten Quadrate eine eindeutige Gerade (oder Hyperebene), die die Summe der Abweichungsquadrate zwischen den wahren Daten und dieser Linie (oder Hyperebene), d. h. die Residuenquadratsumme, minimiert.

Weiterhin wird vorgeschlagen, dass die ersten und zweiten Größen ein Produkt bei seiner Herstellung nach unterschiedlichen Herstellprozesschritten charakterisieren. Beispielsweise kann der zweite Zeitpunkt hier gegeben sein, wenn ein Herstellprozessschritt beendet wurde. Das Produkt kann ein beliebiges Produkt hergestellt in einer Fertigungsstätte sein. Vorzugsweise geht beim Herstellen des Produktes die Nachverfolgbarkeit zu seinen vorhergehenden Prozessschritten verloren (sog. "Schüttgut"), beispielsweise wenn es nicht mehr möglich ist, das Produkt aus dem Schüttgut, z.B. Schrauben, einer Produktionscharge direkt zuzuordnen. Denkbar ist, dass die ersten Größen Komponenten, insbesondere Bauteile, und die zweiten Größen finale Erzeugnisse charakterisieren, wobei die Zuordnungsvorschrift beschreibt, welche Komponente zu welchem Erzeugnis verarbeitet bzw. welches Bauteil in welchem Erzeugnis verbaut wurde. Beispielsweise wenn das Bauteil in dem Erzeugnis nicht mehr zerstörungsfrei herausgenommen werden kann, um eine Seriennummer auszulesen. Mit der Erfindung ist es dann möglich, anhand von Messungen des Erzeugnisses die Produktionscharge des Bauteils zuzuordnen.

Die ersten und zweiten Größen können Mess-/Test-ergebnisse oder anderweitige Eigenschaften der Produkte, Komponenten, usw. sein. Die ersten und zweiten Größen unterscheiden sich vorzugsweise untereinander geringfügig z.B. aufgrund von Fertigungstoleranzen, aber beschreiben die gleichen Messungen/Eigenschaften der Produkte, Komponenten, usw..

Weiterhin wird vorgeschlagen, dass die ersten Größen erste Testergebnisse bzw. Messergebnisse von Halbleiterbauteilelementen auf einem Wafer sind und die zweiten Größen zweite Testergebnisse bzw. Messergebnisse der Halbleiterbauteilelementen nach deren Herausschneiden aus dem Wafer sind. Halbleiterbauteilelemente können Teile von aufgewachsenen elektrischen Bauteilen auf dem Wafer sein, z.B. eine Transistorgruppe einer integrierten Schaltung. Die Testergebnisse können sich auch auf das gesamte Halbleiterbauteil beziehen. Hierbei hat sich für das maschinelle Lernsystem die lineare Regression als besonders effektiv erwiesen, um die beste Zuordnungsvorschrift aufzufinden. Denn diese geht von einem linearen Zusammenhang aus, welcher hier für die Zuordnung der Testergebnisse eine sinnvolle Annahme darstellt. Die lineare Regression ist ein Spezialfall der Regression. Bei der linearen Regression wird dabei eine lineare Funktion angenommen. Es werden also nur solche Zusammenhänge herangezogen, bei denen die abhängige Variable eine Linearkombination der Regressionskoeffizienten (aber nicht notwendigerweise der unabhängigen Variablen) ist.

Weiterhin wird vorgeschlagen, dass die ersten Testergebnisse Wafer-Level Testergebnisse sind und die zweiten Testergebnisse Final-Testergebnisse sind. Vorzugweise liegen weniger Final-Testergebnisse als Wafer-Level Testergebnisse vor. Die Tests sind z.B. Spannungstests und/oder Kontaktierungstests.

Weiterhin wird vorgeschlagen, dass die Halbleiterbauteilelemente auf einer Mehrzahl von unterschiedlichen Wafern hergestellt wurden.

Weiterhin wird vorgeschlagen, dass abhängig von der Zuordnungsvorschrift und der Likelihood-Matrix ermittelt wird, welches zweite Testergebnis zu welchem ersten Testergebnis gehört und wobei dann abhängig von dem zugehörigen ersten Testergebnis ermittelt wird, an welcher Position das Halbleiterbauteil innerhalb eines Wafers angeordnet war. Dies erlaubt eine Positionsrekonstruktion, welche es erstmals ermöglicht, die Halbleiterbauteile aus den letzten Herstellungsprozessschritten der Halbleiterproduktion zu vorhergehenden Prozessschritten eindeutig zurückzuverfolgen. Vorzugsweise wird die Positionsrekonstruktion zusammen mit den jeweils zugehörigen Einträgen der Likelihood-Matrix visualisiert. Dies hat den Vorteil, dass einem Benutzer visuell schnell zugänglich gemacht werden kann, welche Positionsrekonstruktionen weniger zuverlässig sein könnten.

Anhand der Zuordnungsvorschrift und der Likelihood-Matrix kann bei einer Wiederherstellung der Rückverfolgbarkeit zwischen Wafer-Level und endgültigen Testwerten eine genauere Rückverfolgbarkeit erzielt werden, da die Likelihood-Matrix eine Quantifizierung der Unsicherheit der Zuordnungsvorschrift enthält, die es erlaubt bspw. nur sichere Zuordnungen für Rückverfolgung zu verwenden. Eine Zuordnung ist sicher, wenn bspw. ein entsprechender Eintrag der Likelihood-Matrix für die jeweilige Zuordnung größer als ein vorgegebener Wert ist.

Vorteilhafterweise kann die Likelihood-Matrix auch zur Beantwortung probabilistischer Fragen verwendet werden. Beispielsweise kann anhand der Likelihood-Matrix abgeschätzt werden, wie viele ähnliche zweite Größen (bspw. FT-Testergebnisse) existieren gegeben ähnlicher Wahrscheinlichkeitsverteilungen entlang von Spalten der Likelihood-Matrix, oder mit welcher Wahrscheinlichkeit wird Chip A Chip B zugeordnet, oder mit welcher Wahrscheinlichkeit wird ein WLT-Wertebereich gegeben eines FT Testergebnisses gemessen.

Beispielsweise kann basierend auf der Likelihood-Matrix abgeschätzt werden wie wahrscheinlich ist es, dass ein bestimmter Chip als fehlend markiert ist, wobei hierfür eine Zeilensumme der Likelihood-Matrix berechnet wird. Da diese auch höher als 1 sein kann, erfolgt ein cut-off bei 1. Je niedriger die Summe für eine erste Größe (bspw. ein Chip) der zugehörigen Zeile, desto höher ist die Wahrscheinlichkeit, dass dieser als "Fehlend" markiert wird.

Beispielsweise kann auch basierend auf der Likelihood-Matrix abgeschätzt werden, wie zuverlässig die Zuordnung, insbesondere zwischen Wafer-Level und Final-Testergebnisse, ist. Jede Spalte in der Likelihood-Matrix gibt eine Wahrscheinlichkeitsverteilung der Zuordnung eines FT- Testergebnisses an. Je "konzentrierter" diese Verteilungen, desto geringer die Unsicherheit. Bspw. kann ein höchster Wert (= die höchste Wahrscheinlichkeit) durch das .95 Quantil berechnet werden, um ein Maß der Zuverlässigkeit zu ermitteln.

Derartige probabilistische Aussagen anhand der Likelihood-Matrix tragen zu einem tieferen Verständnis des Modells und des Produktionsprozesses bei und kann zu einer besseren Prozesssteuerung führen. Außerdem können Schwellenwerte für die Verwendung bestimmter Zuordnungen für vorgelagerte Aufgaben definiert werden (z. B. nur Zuordnungen mit hoher Wahrscheinlichkeit auswählen).

Weiterhin wird vorgeschlagen, dass zusätzlich zu den Positionen weitere den Wafer und/oder die Halbleiterbauteile auf dem Wafer charakterisierende Größen und jeweils zugeordnete Testergebnisse ermittelt werden, wobei diese Daten zu einem weiteren Trainingsdatensatz zusammengefasst werden, wobei abhängig von dem weiteren Trainingsdatensatz ein weiteres maschinelles Lernsystem angelernt wird, um die zweiten Testergebnisse vorherzusagen.

Der Vorteil hierbei ist, dass die Zuordnung verwendet werden kann, um einen weiteren Trainingsdatensatz zu erstellen, um ein weiteres maschinelles Lernsystem anzulernen, um Eigenschaften eines verpackten Halbleiterbauelements in einem frühen Stadium des Herstellungsprozesses vorherzusagen. Dadurch verkürzt sich die Zeit bis zur Erkennung von Abweichungen in den Prozessparametern erheblich. Insbesondere für Parameter, die nur bei abschließenden Tests (z.B. RDSon) richtig bewertet werden können.

Ein weiterer Vorteil hierbei ist, dass die Zuordnung auch verwendet werden kann, um ein weiteres maschinelles Lernsystem anzulernen, das aktiv defekte Halbleiterchips identifiziert. Das spart Prozessressourcen und reduziert Abfall.

Weiterhin wird vorgeschlagen, dass die Halbleiterbauteilelemente Leistungs-MOSFET (engl. ‚power MOSFET') sind.

In weiteren Aspekten betrifft die Erfindung eine Vorrichtung sowie ein Computerprogramm, die jeweils eingerichtet sind, die obigen Verfahren auszuführen und ein maschinenlesbares Speichermedium, auf dem dieses Computerprogramm gespeichert ist.

Nachfolgend werden Ausführungsformen der Erfindung unter Bezugnahme auf die beiliegenden Zeichnungen näher erläutert. In den Zeichnungen zeigen:

Figur 1    schematisch einen Packaging Prozess;

Figur 2    schematisch ein Ausführungsbeispiel eines Flussdiagramms der Erfindung;

Figur 3    schematisch eine Trainingsvorrichtung.

Beschreibung der Ausführungsbeispiele

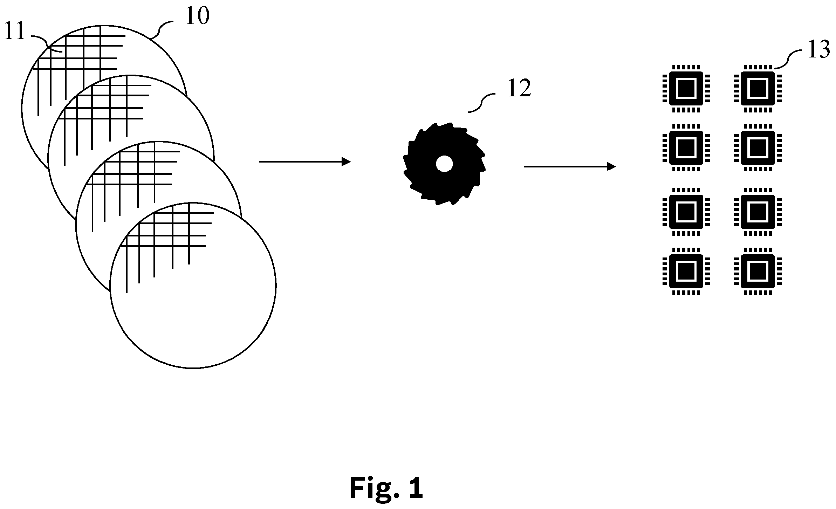

Beim Packaging-Prozess von Halbleiterbauteilen oder Halbleiterbauelementen geht üblicherweise die Rückverfolgbarkeit der Bauelementen zu deren ursprünglichen Wafer und deren ursprünglichen Position auf dem jeweiligen Wafer verloren. Denn nach dem Herausschneiden der Halbleiterbauelementen kann es zu einer Durchmischung der einzelnen Halbleiterbauelemente kommen, wodurch ohne eine eindeutige Markierung der Bauteile deren Position auf dem Wafer verloren geht. Dies ist schematisch in Figur 1 abgebildet. Die Wafer 10 weisen jeweils eine Mehrzahl von Halbleiterbauteilen oder Halbleiterbauelementen 11 auf. In diesem Stadium hat jedes Halbleiterbauelement 11 eine bekannte Position auf den Wafern 10. Üblicherweise werden die Halbleiterbauelemente 11 in diesem Stadium einer Mehrzahl von Test unterzogen, die auch als Wafer-Level Test bezeichnet werden. Daraufhin folgt ein Zerschneiden der Wafer 10, sodass die Halbleiterbauelemente 11 voneinander getrennt werden. Das Zerschneiden kann per Säge 12 oder per Laser erfolgen. Abschließend werden die zugeschnitten Halbleiterbauelemente verpackt, bspw. in Microcontroller 13 eingebaut. Spätestens in diesem Stadium ist dann die Information verloren gegangen, auf welchem Wafer 10 und auf welcher Position innerhalb des Wafers 10 das Halbleiterbauelement ursprünglich positioniert war. Üblicherweise werden die Microcontroller 13 mit den Halbleiterbauelementen 11 wieder einer Mehrzahl von Tests unterzogen, die auch als Final Test bezeichnet werden. Da jedoch durch das Zerschneiden der Wafer 10 eine Durchmischung erfolgte, lässt sich nicht ohne weiteres eindeutig zurückführen, auf welchem Wafer 10 das jeweilige Halbleiterbauelemente 11 der Microcontroller 13 angeordnet war und welcher Wafer-Level Test zu welchem Final Test korrespondiert, also die Testergebnisse des gleich Halbleiterbauelementes sind. Die Halbleiterbauelemente können mikroelektronische Baugruppen, wie z. B. integrierte Schaltungen (im Folgenden auch Chip bezeichnet), Sensoren, o.ä. sein.

Es ist wichtig eine Rückverfolgbarkeit nach dem Verpackungsverfahren in einem Halbleiterherstellungsverfahren zu ermöglichen. Eine solche Zuordnung ermöglicht weitere Beiträge wie eine bessere Prozesskontrolle oder frühzeitige Vorhersagen endgültiger Chip-Eigenschaften. Darüber hinaus kann die Ursachenanalyse, der in der Endprüfung auf Chipebene gemessenen Abweichungen auf die Prozesse in der Wafer Produktion ausgedehnt werden. Dies wiederum ermöglicht ein viel tieferes Verständnis der Prozesse und führt zu einer besseren Prozesskontrolle und damit zu einer besseren Qualität.

Aus der DE 10 2021 209 343 ist ein Zuordnungsalgorithmus zum Ermitteln einer Zuordnungsvorschrift bekannt, der aus einer abwechselnden Abfolge von Optimierung von Regressionsparametern (beim Regressieren aus Wafer-Level-Test auf Final-Test Testdaten) und anschließender Optimierung der Zuordnung von Testpartnern besteht. Die aktuelle Zuordnung der finalen Testchips wird als ‚Regressionslabel' in jeder Iteration verwendet.

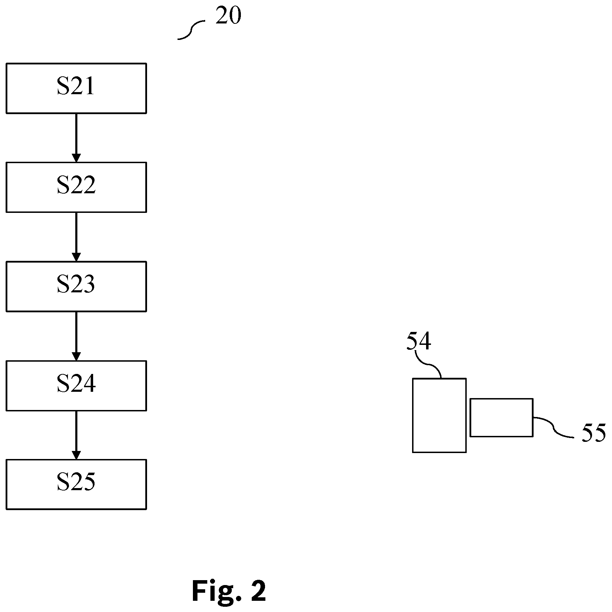

Figur 2 zeigt schematisch ein Flussdiagramm 20 eines Verfahrens zum Abschätzen, insbesondere Ermitteln, einer Unsicherheit der Zuordnungsvorschrift. Die Zuordnungsvorschrift kann Testergebnisse des Final Tests den jeweils korrespondierenden Wafer-Level Test Testergebnissen zuordnen. Nach Beendigung des Verfahrens soll eine Zuordnungsvorschrift sowie eine Abschätzung der Unsicherheit der Zuordnungsvorschrift vorliegen, welche die zusammengehörende Testergebnisse des Wafer-Level Tests zu den Final Tests zuordnet.

Das Verfahren beginnt mit Schritt S21. In diesem Schritt erfolgt ein Bereitstellen eines maschinellen Lernsystems, welches anhand der Zuordnungsvorschrift angelernt wurde, um die ersten Größen gemäß der Zuordnungsvorschrift den zweiten Größen zuzuordnen.

Daraufhin folgt ein Ermitteln (S22) von Ungenauigkeiten $\Delta$ des maschinellen Lernsystems, wobei die Ungenauigkeiten mittels einer Differenz zwischen den vorhergesagten zweiten Größen durch das maschinelle Lernsystem abhängig von den ersten Größen und den den ersten Größen zugeordneten zweiten Größen gemäß der Zuordnungsvorschrift ermittelt werden.

Dann folgt ein Ermitteln (S23) einer Kovarianzmatrix $\Sigma$ abhängig von den ermittelten Ungenauigkeiten.

Anschließend folgt ein Ermitteln (S24) einer Likelihood-Matrix L. Diese kann mit der folgenden Formel berechnet werden:

$$L = \exp\left(-\frac{1}{2}\Delta^T \Sigma^{-1}\Delta\right)$$

Abschließend folgt eine Normalisierung (S25) der Likelihood-Matrix L.

In einen nach Schritt S25 optional folgenden Schritt wird mittels der Zuordnungsvorschrift und der Likelihood-Matrix die Position der Halbleiterbauteile 11 auf dem Wafer 10 rekonstruiert. Hierbei kann anhand der Zuordnungsvorschrift beginnend bei den FT-Testergebnissen rückwärts die WLT-Testergebnisse bestimmt werden, wobei abhängig von der Likelihood-Matrix entschieden wird, ob die Zuordnung durch die Zuordnungsvorschrift verlässlich ist. Da üblicherweise zu den WLT-Testergebnissen zusätzlich abgespeichert wird, an welcher Position innerhalb des Wafers der jeweilige Test ausgeführt wurde, lässt sich somit rekonstruieren, wo genau das entsprechende Halbleiterbauelement auf den Wafer hergestellt wurde.

Denkbar ist, dass abhängig von einer Positionsrekonstruktion ein Steuersignal zur Steuerung eines physikalischen Systems, wie z.B. einer computergesteuerten Maschine, wie einer Fertigungsmaschine, insbesondere Bearbeitungsmaschinen für die Wafer, angesteuert werden. Beispielsweise wenn die FT-Testergebnisse nicht optimal sind, kann das Steuersignal einen vorhergehenden Herstellungsschritt entsprechend anpassen, um später bessere FT-Testergebnisse zu erhalten.

Die Schritte von einer Vorrichtung zum Ausführen des Verfahrens nach Fig. 2 können als Computerprogramm implementiert auf einem maschinenlesbaren Speichermedium 54 hinterlegt sein und von einem Prozessor 55 ausgeführt werden.

## Patentansprüche

1. Computerimplementiertes Verfahren zum Abschätzen einer Unsicherheit einer Zuordnungsvorschrift, die erste Größen aus einer ersten Menge von ersten Größen zweiten Größen aus einer zweiten Menge von zweiten Größen zuordnet, wobei die ersten Größen erste Testergebnisse von Halbleiterbauteilelementen auf einem Wafer sind wobei zu den ersten Testergebnissen zusätzlich abgespeichert ist, an welcher Position innerhalb des Wafers der jeweilige Test ausgeführt wurde, und die zweiten Größen zweite Testergebnisse der Halbleiterbauteilelemente nach deren Herausschneiden aus dem Wafer sind, wobei die Zuordnungsvorschrift charakterisiert, welche ersten und zweiten Testergebnisse vom gleichen Halbleiterbauteilelement stammen, umfassend folgende Schritte:

   Bereitstellen (S21) eines maschinellen Lernsystems, welches anhand der Zuordnungsvorschrift angelernt wurde, um die ersten Größen den zweiten Größen gemäß der Zuordnungsvorschrift zuzuordnen;
   Ermitteln (S22) von Ungenauigkeiten des maschinellen Lernsystems, wobei die Ungenauigkeiten mittels einer Differenz zwischen durch das maschinelle Lernsystem vorhergesagten zweiten Größen, die abhängig von den ersten Größen vorhergesagt werden, und den den ersten Größen zugeordneten zweiten Größen gemäß der Zuordnungsvorschrift ermittelt werden;
   Ermitteln (S23) einer Kovarianzmatrix abhängig von den ermittelten Ungenauigkeiten;
   Ermitteln (S24) einer Likelihood-Matrix (L) der Unsicherheiten der Zuordnungsvorschrift, wobei die ermittelten Ungenauigkeiten zu einem Vektor gruppiert werden, wobei der Vektor ($\Delta$) transponiert mit der invertierten Kovarianzmatrix ($\Sigma$) multipliziert und das Ergebnis hiervon mit dem Vektor ($\Delta$) multipliziert wird gemäß der Formel

   $$L = \exp\left(-\frac{1}{2}\Delta^T \Sigma^{-1}\Delta\right),$$

   und
   Normalisieren (S25) der Likelihood-Matrix (L),
   Ermitteln abhängig von der Zuordnungsvorschrift und der normalisierten Likelihood-Matrix, welches zweite Testergebnis zu welchem ersten Testergebnis gehört, und Ermitteln abhängig von dem zugehörigen ersten Testergebnis, an welcher Position das Halbleiterbauelement innerhalb des Wafers angeordnet war.

2. Verfahren nach Anspruch 1, wobei beim Ermitteln (S24) der Likelihood-Matrix (L), zusätzlich das Ergebnis der Vektor-Matrix-Vektor Multiplikation mit einem vorgegeben Wert skaliert wird und wobei eine Exponentialfunktion auf dieses skalierte Ergebnis angewendet wird.

3. Verfahren nach einem der vorhergehenden Ansprüche, wobei das maschinelle Lernsystem ein Regressionsmodell (53) ist, welches abhängig von den ersten Größen und Parameter des Regressionsmodells die zweiten Größen ermittelt.

4. Verfahren nach Anspruch 1 bis 3, wobei die ersten Testergebnisse Wafer-Level Testergebnisse und die zweiten Testergebnisse Final-Testergebnisse sind.

5. Verfahren nach einem der vorhergehenden Ansprüche, wobei die Halbleiterbauteilelemente auf einer Mehrzahl von unterschiedlichen Wafern hergestellt wurden.

6. Vorrichtung, welche eingerichtet ist, das Verfahren nach einem der vorhergehenden Ansprüche auszuführen.

7. Computerprogramm, umfassend Befehle, die bei der Ausführung des Programms durch einen Computer diesen veranlassen, das Verfahren nach Anspruch 1 bis 5 auszuführen.

8. Maschinenlesbares Speichermedium (55), auf dem das Computerprogramm nach Anspruch 7 gespeichert ist.

**Claims**

1. Computer-implemented method for estimating an uncertainty of an assignment rule that assigns first variables from a first set of first variables to second variables from a second set of second variables, wherein the first variables are first test results of semiconductor components on a wafer, wherein, in relation to the first test results, the position within the wafer at which the respective test was carried out is additionally stored, and the second variables are second test results of the semiconductor components after they have been cut out from the wafer, wherein the assignment rule characterizes which first and second test results originate from the same semiconductor component, comprising the following steps:

   providing (S21) a machine learning system that has been trained, based on the assignment rule, to assign the first variables to the second variables in accordance with the assignment rule;
   determining (S22) inaccuracies of the machine learning system, wherein the inaccuracies are determined by way of a difference between second variables predicted by the machine learning system, which are predicted depending on the first variables, and the second variables assigned to the first variables in accordance with the assignment rule;
   determining (S23) a covariance matrix depending on the determined inaccuracies;
   determining (S24) a likelihood matrix (L) of the uncertainties of the assignment rule, wherein the determined inaccuracies are grouped into a vector, wherein the vector ($\Delta$) is transpose-multiplied by the inverted covariance matrix ($\Sigma$) and the result thereof is multiplied by the vector ($\Delta$) according to the formula

$$L = \exp\left(-\frac{1}{2}\Delta^T \Sigma^{-1}\Delta\right),$$

   and
   normalizing (S25) the likelihood matrix (L),
   determining, depending on the assignment rule and the normalized likelihood matrix, which second test result belongs to which first test result, and determining, depending on the associated first test result, the position at which the semiconductor component was arranged within the wafer.

2. Method according to Claim 1, wherein, when determining (S24) the likelihood matrix (L), the result of the vector-matrix-vector multiplication is additionally scaled with a predefined value and wherein an exponential function is applied to this scaled result.

3. Method according to either of the preceding claims, wherein the machine learning system is a regression model (53) that determines the second variables depending on the first variables and parameters of the regression model.

4. Method according to Claims 1 to 3, wherein the first test results are wafer-level test results and the second test results are final test results.

5. Method according to one of the preceding claims, wherein the semiconductor components were produced on a plurality of different wafers.

6. Device configured to carry out the method according to one of the preceding claims.

7. Computer program comprising instructions that, when the program is executed by a computer, cause the latter to carry out the method according to Claims 1 to 5.

8. Machine-readable storage medium (55) on which the computer program according to Claim 7 is stored.

**Revendications**

1. Procédé mis en œuvre par ordinateur pour estimer une incertitude d'une règle d'affectation affectant des premières variables d'un premier ensemble de premières variables à des secondes variables d'un second ensemble de secondes variables, les premières variables étant des premiers résultats de test d'éléments de composants semi-conducteurs sur une tranche, les premiers résultats de test stockant en outre la position à laquelle le test respectif a été effectué à l'intérieur de la tranche, et les secondes variables étant des seconds résultats de test des composants semi-conducteurs après qu'ils ont été découpés dans la tranche, la règle d'affectation caractérisant quels premiers et seconds résultats de test proviennent d'un même composant semi-conducteur, comprenant les étapes suivantes :

fournir (S21) un système d'apprentissage automatique qui a été entraîné sur la base de la règle d'affectation afin d'affecter les premières variables aux secondes variables conformément à la règle d'affectation ;
déterminer (S22) des imprécisions du système d'apprentissage automatique, les imprécisions étant déterminées au moyen d'une différence entre des secondes variables prédites par le système d'apprentissage automatique et prédites sur la base des premières variables et des secondes variables affectées aux premières variables conformément à la règle d'affectation ;
déterminer (S23) une matrice de covariance en fonction des imprécisions déterminées ;
déterminer (S24) une matrice de vraisemblance (L) des incertitudes de la règle d'affectation, les imprécisions déterminées étant regroupées en un vecteur, le vecteur ($\Delta$) transposé étant multiplié par la matrice de covariance inversée ($\Sigma$) et le résultat ainsi obtenu étant multiplié par le vecteur ($\Delta$) selon la formule

$$L = \exp\left(-\frac{1}{2}\Delta^T \Sigma^{-1}\Delta\right),$$

et
normaliser (S25) la matrice de vraisemblance (L),
déterminer, en fonction de la règle d'affectation et de la matrice de vraisemblance normalisée, quel second résultat de test appartient à quel premier résultat de test, et déterminer, en fonction du premier résultat de test associé, à quelle position le composant semi-conducteur était disposé dans la tranche.

2. Procédé selon la revendication 1, dans lequel, lors de la détermination (S24) de la matrice de vraisemblance (L), le résultat de la multiplication vecteur-matrice-vecteur est mis à l'échelle à l'aide d'une valeur prédéfinie, et une fonction exponentielle est appliquée à ce résultat mis à l'échelle.

3. Procédé selon l'une quelconque des revendications précédentes, dans lequel le système d'apprentissage automatique est un modèle de régression (53) qui détermine les secondes variables en fonction des premières variables et de paramètres du modèle de régression.

4. Procédé selon les revendications 1 à 3, dans lequel les premiers résultats de test sont des résultats de test au niveau de la tranche et les seconds résultats de test sont des résultats de test finaux.

5. Procédé selon l'une quelconque des revendications précédentes, dans lequel les composants semi-conducteurs ont été fabriqués sur une pluralité de tranches différentes.

6. Dispositif qui est conçu pour mettre en œuvre le procédé selon l'une quelconque des revendications précédentes.

7. Programme informatique comprenant des instructions qui, lors de l'exécution du programme par un ordinateur, amènent ce dernier à mettre en œuvre le procédé selon les revendications 1 à 5.

8. Support de stockage lisible par machine (55), sur lequel est stocké le programme informatique selon la revendication 7.

Fig. 1

```
         20

    ┌─────────┐
    │   S21   │
    └─────────┘
         │
         ▼
    ┌─────────┐
    │   S22   │
    └─────────┘
         │
         ▼
    ┌─────────┐
    │   S23   │
    └─────────┘
         │
         ▼
    ┌─────────┐
    │   S24   │
    └─────────┘
         │
         ▼
    ┌─────────┐
    │   S25   │
    └─────────┘
```

54

55

**Fig. 2**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102021209343
- US 7868474 B2

- US 5256578 A